# EUROPEAN PATENT APPLICATION

(11) **EP 4 336 974 A1**
(43) Date of publication of application: **13.03.2024**
(21) Application number: 22194320.2
(22) Date of filing: 07.09.2022
(51) Int. Cl.: H05K 1/02, B60Q 1/00, H05K 3/22

(54) **ELECTRONIC SUBSTRATE AND AUTOMOTIVE LIGHTING DEVICE FOR AN AUTOMOTIVE VEHICLE**

(71) Applicant: Valeo Vision, 93012 Bobigny Cedex (FR)
(72) Inventor: CANTUDO FRANCO, Miguel Angel, 23600 Martos (ES); JURADO TRUJILLO, Jesus, 23600 Martos (ES)
(74) Representative: Valeo Visibility

(57) **Abstract**

The invention is related to an electronic substrate (1) for an automotive lighting device. This electronic substrate (1) comprises a power input (2), a control unit (3) and first and second circuits, connecting, by their corresponding set of conductive tracks (4, 5), the power input (2) with a first input of the control unit (3). The substrate also comprises two discontinuities (6, 8) which comprises a portion of the substrate (1) and a portion of the corresponding set of conductive tracks (4, 5), leaving the corresponding circuit open. The invention also refers to a lighting device comprising such an electronic substrate (1).

## Description

### FIELD OF THE INVENTION

The present invention generally relates to an electronic substrate for a lighting device of a vehicle and to a lighting device comprising such a substrate.

### STATE OF THE ART

Lighting devices are an integral part of automotive vehicles. The lighting devices may be of various types such as headlamps, tail lamps, signal lamps, and the like, which may be used for different functions of the automotive vehicle. The lighting device of an automotive vehicle may perform different lighting functions such as providing a low beam, a high beam, a turn signal indicator, daytime running lamps, tail light, turn signal indication, fog light, and the like by utilizing the lighting device. The lighting device is configured to provide different light output for different lighting functions by utilizing an electronic assembly. The electronic assembly is connected between a power supply and a light source of the lighting device. The electronic assembly receives the power supply from the battery of the vehicle as power input and transforms this power input into a signal which is suitable for the lighting device to provide different lighting functions.

Usually, the automotive brand may have different models, each model having in turn different versions, depending on consumer demand. Further, different countries have different lighting regulations, so the same model in the same version may have two alternatives (e.g. for EU and for US). Each version and variant of the automotive vehicle may have the same or different lighting functions. For example, a high end version of the vehicle may provide a signature lighting function whereas a low end version of the same vehicle may not provide the signature lighting function due to cost consideration, but may have the same lighting functions as the medium range version. In this case, the structure remains very similar, causing the assembly operator to be easily mistaken with the different versions of very similar circuit boards.

The "background" description provided herein is for purposes of presenting the general context of the disclosure. Work of the presently named inventors, to the extent it is described in this background section, as well as aspects of the description, which may not otherwise qualify as conventional art at the time of filing, are neither expressly nor impliedly admitted as conventional art against the present disclosure.

### SUMMARY OF THE INVENTION

The present invention is directed to an improved electronic substrate for a vehicle that solves the aforementioned problem.

In a first inventive aspect, the invention provides an electronic substrate for an automotive lighting device, the electronic substrate comprising
- a power input;
- a control unit;
- a first circuit connecting, by a first set of conductive tracks, the power input with a first input of the control unit;
- a second circuit connecting, by a second set of conductive tracks, different from the first set of conductive tracks, the power input with a second input of the control unit;
- a first discontinuity which comprises a portion of the substrate and a portion of the first set of conductive tracks leaving the first circuit open; and
- a second discontinuity which comprises a portion of the substrate and a portion of the second set of conductive tracks, leaving the second circuit open.

This invention allows the provision of a single reference of an electronic substrate for different variations of lighting devices, due to different versions or country specifications (ECE, FMVSS, etc). When a specific version is chosen, this specific version corresponds to a specific input in the control unit. The discontinuities are physical holes or detachments in the substrate, comprising a portion of the tracks. When choosing the suitable circuit that connects this specific input with the power input is the circuit that should be closed when installed in the housing. The rest of the circuits should be left open, so that no other input is fed in the control unit. This is achieved by introducing a pin in the circuit which corresponds to the chosen version.

With this invention, a single reference is provided to face different options, thus saving time and cost. The differentiation is done in the assembly line, just by adding a pin in the correct position.

In some particular embodiments, the electronic substrate further comprises
- at least a further circuit, each further circuit connecting, by their corresponding set of conductive tracks, the power input with the control unit; and
- at least a further discontinuity, each discontinuity comprising a portion of the substrate and a portion of the corresponding set of conductive tracks, thus leaving the corresponding circuit open.

The provision of a greater number of circuits, with their corresponding discontinuities, provides a way of different car models, different versions, different regulations...). It is easy that for the same substrate reference, 8, 10 or 12 different options may be available.

In some particular embodiments, at least one set of conductive tracks comprises a zero-ohm resistor suitable for reducing corrosion.

In some particular embodiment, each discontinuity has a different shape. Thus, the operator does not have to look at complex codes when installing the substrate. In fact, a different shape for each discontinuity will cause that the substrate will only fit in a housing when it has a pin with the corresponding shape.

In some particular embodiments, the substrate is a printed circuit board.

In a second inventive aspect, the invention provides an automotive lighting device comprising:
- an electronic substrate according to the first inventive aspect;
- at least one light source arranged in the electronic substrate to be controlled by the control unit; and
- a housing configured to receive the substrate, the housing comprising at least one control part configured to close one of the circuits by closing a contact between portions of the same conductive track when the substrate is installed in the housing.

This automotive lighting device may be designed with its own housing, which is specifically adapted for the model, version and standard regulation. The housing itself comprises a physical control part intended to prevent a wrong configuration of the electronic substrate.

In some particular embodiments, the light source is a solid-state light source.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the lifespan of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas.

In some particular embodiments, the automotive lighting device is configured to provide a rear lamp function, a stop lamp function, a rear direction indicator lamp function and a fog lamp function.

A rear device is more prompt to suffer from these variations in functionalities and regulations. However, this invention may be applied to a headlamp as well.

In some particular embodiments, the control part is made of the same material as the housing and has a metallizing coating.

The control part may be, in some cases, be created in the same moulding process as the rest of the housing, while the conductive properties are provided afterwards by a metallizing coating. Hence, due to these acquire properties, it is able to close the circuit when inserted in the corresponding discontinuity.

In a further inventive aspect, the invention provides a method for assembling an automotive lighting device, comprising the steps of
- providing a substrate according to the first set of claims;
- providing a light source in the substrate;
- closing one of the circuits by introducing a metallic pin in one of the discontinuities; and
- installing the substrate in a housing.

With this method, the operator has an easy task for closing the circuit before installing the substrate in the housing. The substrate may be automatically placed in the correct place of the housing to perform its function.

In some particular embodiments, the housing further comprises non-conductive control elements which fit with the non-closed discontinuity.

These non-conductive elements act as poka yoke elements, preventing the substrate to be incorrectly installed.

In a further inventive aspect, the invention provides a method for assembling an automotive lighting device, comprising the steps of
- providing a substrate according to the first inventive aspect;
- providing a light source in the substrate;
- choosing one of the discontinuities, corresponding to an option which is desired; and
- installing the substrate in a housing, wherein the housing comprises a conductive pin which fits only with the chosen discontinuities.

In this method, there is no need to perform a previous circuit-closing action by the operator: the pin which is already comprised in the design of the housing (and that may be metallized after demoulding) is in charge of closing the circuit at the same time the substrate is installed in the housing.

In some particular embodiments, the housing further comprises non-conductive control elements which fit with the non-chosen discontinuity.

These non-conductive elements act as poka yoke elements, preventing the substrate to be incorrectly installed.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

### DESCRIPTION OF DRAWINGS

To further provide a more encompassing description and a better understanding of the invention, a set of drawings is provided. Said drawings form an integral part of the description and illustrate embodiment aspects of the invention, which should not be construed as restricting the scope of the invention, but only as examples of how the invention can be carried out. The drawings comprise the following characteristics:
FIG. 1 shows an electronic assembly for a vehicle, according to an embodiment of the present invention.
FIG. 2 shows the particular location of the housing where the printed circuit board is to be installed.

In these figures, the following reference numbers have been used:
- 1 Printed circuit board
- 2 Power input
- 3 Control unit
- 4 First set of conductive tracks
- 5 Second set of conductive tracks
- 6 First discontinuity
- 8 Second discontinuity
- 9 Third set of conductive tracks
- 10 Fourth set of conductive tracks
- 11 Third discontinuity
- 12 Fourth discontinuity
- 13 Zero-ohm resistor
- 14 LED
- 15 Housing
- 16 Physical control parts

### DETAILED DESCRIPTION OF PREFERRED EMBODIMENTS

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

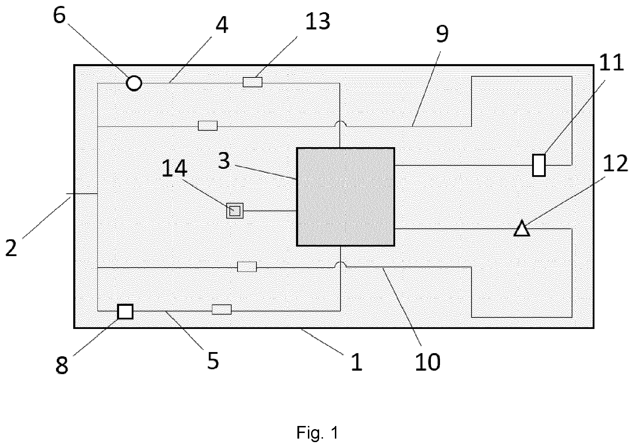

FIG.1 shows a printed circuit board 1 according to the invention. This printed circuit board 1 is intended to be installed in an automotive lighting device, as will be shown later. This printed circuit board 1 comprises a power input 2 and a control unit 3.

The power input 2 is common for this type of elements: a 3.3V input, a 5V input or a 12V input are typical examples of the power feeding of these elements. The control unit 3 is in charge of controlling a group of LEDs which are intended to provide different lighting and signaling functions.

This printed circuit board 1 comprises four different circuits. Each one of these four different circuits corresponds to a configuration option. For example, first and second circuits may correspond to ECE versions, while third and fourth circuits may correspond to an FMVSS version. First and third circuits may correspond to basic versions while second and fourth circuits may correspond to premium versions.

Each circuit has a set of conductive tracks which connect the same power input 2 with a corresponding input of the control unit 3. The control unit 3 is configured to recognize which is the fed input and then, when power is provided through this input, the control unit 3 provides the required functionalities corresponding to the chosen option.

The printed circuit board 1 also comprises a plurality of discontinuities 6, 8, 11, 12, one per each circuit. Each discontinuity comprises a part of the printed circuit board (i.e., it means a "hole" in the printed circuit board) and also a portion of the corresponding set of conductive tracks 4, 5, 9, 10, in such a way that every circuit remains open by default, unless any conductive element is inserted in the discontinuity, thus closing the circuit.

Then, when a specific model and version is to be assembled, only one circuit is closed to provide the specific configuration, the rest of the circuits which correspond to the non-chosen options should be left open when installing the printed circuit board in the lighting device.

Each circuit comprises a zero-ohm resistor 13, suitable for reducing corrosion.

In the embodiment of the figure, the printed circuit board comprises four discontinuities 6, 8, 11, 12, each one being located in the path of each corresponding set of conductive tracks. Each discontinuity has a different shape. First discontinuity 6 has a circular shape, second discontinuity 8 has a square shape, third discontinuity 11 has a rectangular shape and fourth discontinuity 12 has a triangular shape. Hence, each option may be easily identifiable even without further investigation.

Each discontinuity is open by default, and there are two options when facing the installation of this substrate.

First option is that the operator manually closes the chosen circuit by installing a pin, thus leaving closed only the circuit which corresponds to the chosen option. Then, once the printed circuit board is prepared, then is installed in the housing.

Hence, if the vehicle where the printed circuit board is going to be installed has a premium version and is to be sold in EU market, the second circuit is chosen, and the operator will put a square pin in the second discontinuity 8.

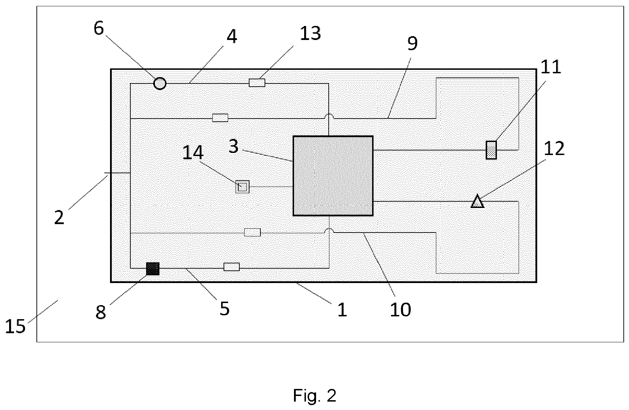

Figure 2 shows the particular location of the housing where the printed circuit board is to be installed. In this case, the housing comprises some physical control parts which takes the space of the discontinuities, so that the printed circuit board cannot be incorrectly installed in the housing. However, only the control part corresponding to the chosen option, which in this case is the second circuit, corresponding to the second discontinuity 8, is metallized, while the rest of the control part are not treated, remaining non-conductive. When the printed circuit board 1 is installed in this housing, the metallized control part will automatically close the chosen circuit, while the rest will remain open.

## Claims

1. An electronic substrate (1) for an automotive lighting device, the electronic substrate (1) comprising
a power input (2);
a control unit (3);
a first circuit connecting, by a first set of conductive tracks (4), the power input (2) with a first input of the control unit (3);
a second circuit connecting, by a second set of conductive tracks (5), different from the first set of conductive tracks (4), the power input (2) with a second input of the control unit (3);
a first discontinuity (6) which comprises a portion of the substrate (1) and a portion of the first set of conductive tracks (4) leaving the first circuit open; and
a second discontinuity (8) which comprises a portion of the substrate (1) and a portion of the second set of conductive tracks (5), leaving the second circuit open.

2. The electronic substrate (1) according to claim 1, further comprising
at least a further circuit, each further circuit connecting, by their corresponding set of conductive tracks (9, 10), the power input with the control unit (3); and
at least a further discontinuity (11, 12), each discontinuity comprising a portion of the substrate and a portion of the corresponding set of conductive tracks (9, 10), thus leaving the corresponding circuit open.

3. The electronic substrate (1) according to any of the preceding claims, wherein at least one set of conductive tracks (4, 5, 9, 10) comprises a zero-ohm resistor (13) suitable for reducing corrosion.

4. The electronic substrate (1) according to any of the preceding claims, wherein each discontinuity has a different shape.

5. The electronic substrate (1) according to any of the preceding claims, wherein the substrate (1) is a printed circuit board.

6. An automotive lighting device comprising:
an electronic substrate (1) according to any of the preceding claims;
at least one light source (14) arranged in the electronic substrate (1) to be controlled by the control unit (3);
a housing (15) configured to receive the substrate (1), the housing comprising at least one control part (16) configured to close one of the circuits by closing a contact between portions of the same conductive track when the substrate (1) is installed in the housing (15).

7. The automotive lighting device according to claim 6, wherein the light source (14) is a solid-state light source.

8. The automotive lighting device according to any of claims 6 or 7, being configured to provide a rear lamp function, a stop lamp function, a rear direction indicator lamp function and a fog lamp function.

9. The automotive lighting device according to any of claims 6 to 8, wherein the control part (16) is made of the same material as the housing and has a metallizing coating.

10. Method for assembling an automotive lighting device, comprising the steps of
providing a substrate according to any of claims 1 to 5
providing a light source in the substrate
closing one of the circuits by introducing a metallic pin in one of the discontinuities
installing the substrate in a housing.

11. Method according to claim 10, wherein the housing further comprises non-conductive control elements which fit with the non-closed discontinuity.

12. Method for assembling an automotive lighting device, comprising the steps of
providing a substrate according to any of claims 1 to 5;
providing a light source in the substrate;
choosing one of the discontinuities, corresponding to an option which is desired; and
installing the substrate in a housing, wherein the housing comprises a conductive pin which fits only with the chosen discontinuities.

13. Method according to claim 12, wherein the housing further comprises non-conductive control elements which fit with the non-chosen discontinuity.
